# EUROPEAN PATENT SPECIFICATION

(11) **EP 4 194 819 B1**
(45) Date of publication and mention of the grant of the patent: **05.03.2025**
(21) Application number: 22212214.5
(22) Date of filing: 08.12.2022
(51) Int. Cl.: G01F 23/296, B06B 1/06, H10N 30/073

(54) **SENSOR HAVING A PIEZOELECTRIC ELEMENT AND MANUFACTURING METHOD THEREOF**
SENSOR MIT EINEM PIEZOELEKTRISCHEN ELEMENT UND DESSEN HERSTELLUNGSVERFAHREN
CAPTEUR COMPRENANT UN ÉLÉMENT PIÉZOÉLECTRIQUE ET SON PROCÉDÉ DE FABRICATION

(30) Priority: 10.12.2021 US 202117547743
(43) Date of publication of application: 14.06.2023
(73) Proprietor: TE Connectivity Solutions GmbH, 8200 Schaffhausen (CH)
(72) Inventor: Pedrick, Michael, Hampton (US); Ritchie, Michael, Hampton (US); Matzeder, Jodi, Hampton (US); Vawter, John, Hampton (US); Rubiano, Achilles, Hampton (US)
(74) Representative: Grünecker Patent- und Rechtsanwälte PartG mbB

(56) References cited:
- DE-B3- 102005 018 824
- US-A- 5 966 983
- US-A1- 2013 313 084
- US-B2- 10 598 634

## Description

The present invention relates to a sensor and, more particularly, to a sensor having a piezoelectric element.

Sensors incorporating a piezoelectric element can require a substrate to support the piezoelectric element and an adhesive to attach the piezoelectric element to the substrate. To construct the sensor, the piezoelectric element is positioned on the substrate and the adhesive is often deposited over an entirety of the piezoelectric element, surrounding the piezoelectric element on all sides.

The adhesive is prone to shrinking when cured and, due to the amount of the adhesive attaching the piezoelectric element to the substrate and the position of the adhesive surrounding the piezoelectric element, shrinkage of the adhesive bends the piezoelectric element around a bending point of the substrate. The bending stresses the piezoelectric element and, in subsequent thermal cycling during use, leads to the propagation of cracks and failure of the piezoelectric element, resulting in unreliable sensor performance and limited longevity.

US 2013/313084 A1 discloses a vibration limit switch system with a piezoelectric transmitting unit which is in operable connection with a membrane that can be put in oscillation. The piezoelectric transmitting unit is adhered to the membrane.

US 5 966 983 A relates to an assembly for sensing and/or monitoring the level of a material in a vessel. The assembly includes a level sensor. In one embodiment, a piezoelectric transducer is secured inside a hollow tube by bonding, for which an adhesive is used.

DE 10 2005 018824 B3 shows a device for detecting the level of a fluid inside a vessel. The device comprises a piezoelectric transducer, a metal housing, an adhesive and a plastic housing. The piezoelectric transducer is connected to the housing via the adhesive, so that mechanical signals can be transmitted between the transducer and the housing.

US 10 598 634 B2 relates to a monitoring arrangement of construction components in mechanical systems. The arrangement comprises a transducer that is connected to a construction component via a couplant.

A sensor includes a substrate having a curved surface, a piezoelectric element, and an adhesive disposed between the piezoelectric element and the curved surface along a vertical direction. The adhesive attaches the piezoelectric element to the substrate. The adhesive has an exterior bond surface that has a tapered shape along the vertical direction from the piezoelectric element to the curved surface. The adhesive has a planar side and a curved side opposite the planar side, the planar side abuts an inner surface of the piezoelectric element and the curved side abuts the curved surface, wherein the exterior bond surface extends between the planar side and the curved side and defines a lateral extent of the adhesive in a width direction extending perpendicular to the vertical direction. The lateral extent of the adhesive is greater at the planar side attached to the piezoelectric element than at the curved side attached to the curved surface.

The invention will now be described by way of example with reference to the accompanying Figures, of which:
Figure 1 is a schematic sectional side view of a sensor according to an embodiment of the invention;
Figure 2A is a schematic sectional side view of an exemplary first step not forming part of the present invention of constructing the sensor of Figure 1;
Figure 2B is a schematic sectional side view of an exemplary next step not forming part of the present invention of constructing the sensor of Figure 1;
Figure 2C is schematic sectional side view of an exemplary final step not forming part of the present invention of constructing the sensor of Figure 1;
Figure 3 is a schematic sectional side view of a step of constructing the sensor of Figure 1 according to an embodiment of the present invention; and
Figure 4 is a schematic sectional side view of a sensor assembly according to an embodiment.

Exemplary embodiments of the present disclosure will be described hereinafter in detail with reference to the attached drawings, wherein like reference numerals refer to like elements. The present disclosure may, however, be embodied in many different forms and should not be construed as being limited to the embodiments set forth herein; rather, these embodiments are provided so that the present disclosure will convey the concept of the disclosure to those skilled in the art. In addition, in the following detailed description, for purposes of explanation, numerous specific details are set forth in order to provide a thorough understanding of the disclosed embodiments, the invention being defined by the appended claims.

Throughout the specification, directional descriptors are used such as "width", "vertical", and "longitudinal". These descriptors are merely for clarity of the description and for differentiation of the various directions. These directional descriptors do not imply or require any particular orientation of the disclosed elements.

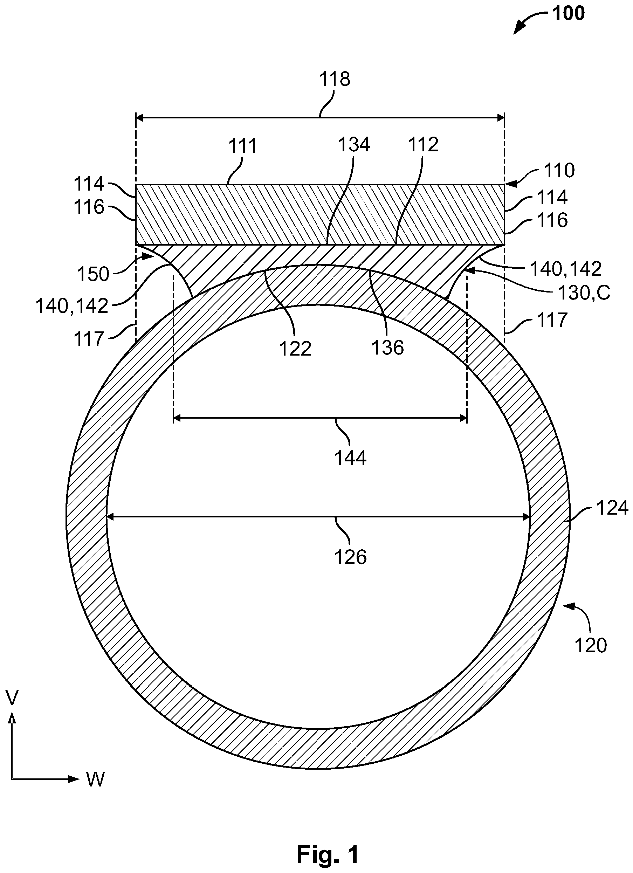

A sensor 100 according to an embodiment is shown in Figure 1. The sensor 100 includes a piezoelectric element 110, a substrate 120, and an adhesive 130 attaching the piezoelectric element 110 to the substrate 120.

The piezoelectric element 110, as shown in the embodiment of Figure 1, has an outer surface 111 and an inner surface 112 opposite the outer surface 111 in a vertical direction V. A plurality of side surfaces 114 extend between the inner surface 112 and the outer surface 111 along the vertical direction V and define a perimeter 116 of the piezoelectric element 110 in a width direction W perpendicular to the vertical direction V. The piezoelectric element 110 has a piezoelectric width 118 in the width direction W. In the embodiment shown in Figure 1, the piezoelectric element 110 is a planar element extending in a plane normal to the vertical direction V.

The piezoelectric element 110 may be any type of element that vibrates when an extemal voltage is applied to the element. The piezoelectric element 110, in various embodiments, may be a film, a composite, a ceramic, or a crystal. In an embodiment, the piezoelectric element 110 is a brittle piezoelectric element, such as a hard ceramic piezoelectric or a single crystal piezoelectric.

As shown in Figure 1, the substrate 120 has a curved surface 122 facing the piezoelectric element 110 along the vertical direction V. In an embodiment, the substrate 120 has a cylindrical shape 124, such as a cylinder or a tube, extending perpendicular to the vertical direction V and the width direction W and having a circular cross-section forming the curved surface 122. In other embodiments, the substrate 120 could have shapes other than the cylindrical shape 124 and cross-sections other than the circular cross-section shown in Figure 1, provided that the substrate 120 has the curved surface 122 facing the piezoelectric element 110 as described herein. In an embodiment, the substrate 120 is formed of a metal material. In other embodiments, the substrate 120 can alternatively be formed of a plastic material.

The cylindrical shape 124 of the substrate 120 in the embodiment shown in Figure 1 has an inner diameter 126. In an embodiment, a ratio of the piezoelectric width 118 to the inner diameter 126 is greater than or equal to 0.2 and less than or equal to 2.0. In another embodiment, the ratio of the piezoelectric width 118 to the inner diameter 126 is greater than or equal to 0.5 and less than or equal to 1.0.

The adhesive 130 is disposed between the piezoelectric element 110 and the substrate 120 along the vertical direction V. In an embodiment, the adhesive 130 is a thermoset adhesive that cures at a temperature greater than room temperature. In other embodiments, the adhesive 130 may be an epoxy, a polyurethane, an acrylic, or any other type of adhesive material, and may be cured by the application of heat greater than room temperature, may be cured at room temperature, may be cured by mixing with a chemical catalyst, or may be cured by the application of radiation, such as ultraviolet light. As used throughout the present specification, the term "room temperature" is intended to be a range of greater than or equal to 20°C and less than or equal to 25°C.

The adhesive 130 is shown in a cured state C in Figure 1, in which the adhesive 130 is adhered to both the piezoelectric element 110 and the substrate 120 and attaches the piezoelectric element 110 to the curved surface 122 of the substrate 120. As shown in Figure 1, in the cured state C, the adhesive 130 has a planar side 134 and a curved side 136 opposite the planar side 134 in the vertical direction V. The planar side 134 corresponds to a shape of the inner surface 112 of the piezoelectric element 110 and, in the shown embodiment, extends fully across the inner surface 112 in the width direction W. The planar side 134 abuts the inner surface 112 and is adhered to the inner surface 112 in the cured state C. The curved side 136 corresponds to a shape of the curved surface 122 of the substrate 120 and extends across a portion of the curved surface 122. The curved side 136 abuts the curved surface 122 and is adhered to the curved surface 122 in the cured state C.

As shown in Figure 1, the adhesive 130 has an exterior bond surface 140 extending between the planar side 134 and the curved side 136. In the cured state C, the exterior bond surface 140 has a tapered shape 142 along the vertical direction V from the piezoelectric element 110 to the curved surface 122. The tapered shape 142 is curved inward or concavely in the cured state C in the embodiment shown in Figure 1. In other embodiments, in the cured state C, the tapered shape 142 may have an outward or convex curve, may extend in a linear manner, or may extend in an irregular manner from the piezoelectric element 110 to the curved surface 122.

The exterior bond surface 140 defines a lateral extent 144 of the adhesive 130 in the width direction W, as shown in Figure 1. Due to the tapered shape 142 of the exterior bond surface 140, the lateral extent 144 of the adhesive 130 is greater at the planar side 134 attached to the piezoelectric element 110 than at the curved side 136 attached to the curved surface 122. Figure 1 shows one exemplary lateral extent 144 approximately halfway along the exterior bond surface 140, but the lateral extent 144 follows the tapered shape 142 and is a different quantity in the width direction W at different positions along the exterior bond surface 140.

Figure 1 shows a vertical projection 117 of the perimeter 116 of the piezoelectric element 110 in the vertical direction V toward the curved surface 122. In the cured state C, the lateral extent 144 of the adhesive 130 is disposed within the vertical projection 117 of the perimeter 116. The planar side 134 of the adhesive 130 is disposed along either an entirety of the inner surface 112 or less than an entirety of the inner surface 112 in the width direction W, and the lateral extent 144 of the adhesive 130 at the planar side 134 does not extend beyond the vertical projection 117 of the perimeter 116. The curved side 136 has a narrower lateral extent 144 in the width direction W than the planar side 134, due to the tapered shape 142, and is also within the vertical projection 117.

In the embodiment shown in Figure 1, the adhesive 130 is a matching layer 150 that matches a mechanical impedance between the piezoelectric element 110 and the substrate 120. To act as the matching layer 150, in some embodiments, the mechanical impedance of the adhesive 130 either equals the mechanical impedances of the piezoelectric element 110 and the substrate 120 or transitions between the mechanical impedances of the piezoelectric element 110 and the substrate 120, for example having a mechanical impedance that is approximately an average of the mechanical impedances of the piezoelectric 110 and the substrate 120. In other embodiments, in which the impedance of the adhesive 130 is not physically able to be between the impedance of the piezoelectric element 110 and the impedance of the substrate 120, the impedance of the matching layer 150 is selected to optimize signal efficiency; in this embodiment, the impedance of the matching layer 150 may be below the impedances of both the piezoelectric element 110 and the substrate 120.

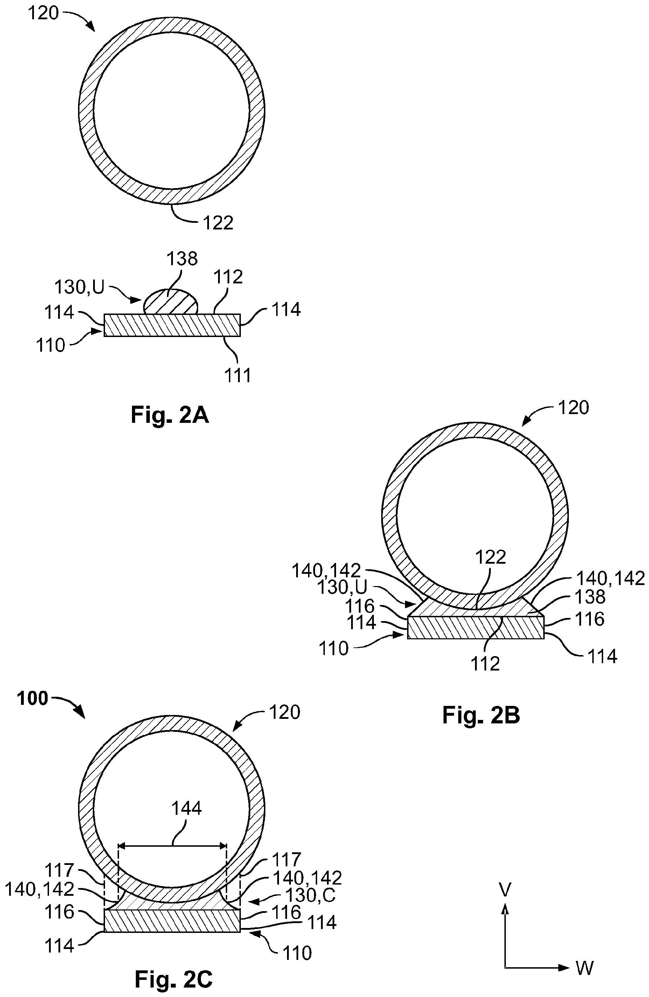

An exemplary method not forming part of the present invention shown in Figures 2A-2C of constructing the sensor 100 shown in Figure 1 will now be described in greater detail.

In a first step shown in Figure 2A, the piezoelectric element 110 is positioned on the outer surface 111 with the inner surface 112 exposed and facing up in the vertical direction V. The adhesive 130 is deposited in an uncured state U on the inner surface 112. A predetermined volume 138 of the adhesive 130 in the uncured state U is deposited in this step. The predetermined volume 138 of the adhesive 130 is liquid or semi-solid in the uncured state U; the adhesive 130 is capable of changing shape in the uncured state U under the external forces described herein.

With the adhesive 130 in the uncured state U on the inner surface 112 of the piezoelectric element 110, the substrate 120 is moved in the vertical direction V toward the inner surface 112 of the piezoelectric element 110 and into contact with the adhesive 130. As shown in Figure 2B, the curved surface 122 of the substrate 120 contacts the adhesive 130 and spreads the adhesive 130 in the uncured state U between the inner surface 112 and the curved surface 122.

Due to the predetermined volume 138 of the adhesive 130, the adhesive 130 spreads along the inner surface 112 of the piezoelectric element 110 and covers the inner surface 112, and spreads along and covers a portion of the curved surface 122 of the substrate 120, as shown in Figure 2B. The predetermined volume 138 limits the spread of the adhesive 130 and prevents the adhesive 130 from extending or flowing beyond the perimeter 116 at the side surfaces 114 of the piezoelectric element 110 in the width direction W. The predetermined volume 138 also creates the tapered shape 142 of the exterior bond surface 140 in the uncured state U, as shown in Figure 2B.

With the substrate 120 positioned with respect to the piezoelectric element 110 as shown in Figure 2B, and the adhesive 130 in the uncured state U between the piezoelectric element 110 and the substrate 120, the adhesive 130 is cured to the cured state C to attach the piezoelectric element 110 to the substrate 120 and form the sensor 100 shown in Figures 1 and 2C. As described above, depending on the type of the adhesive 130, the adhesive 130 can be cured by the application of a temperature greater than room temperature, or can be cured at other temperatures, by mixing with a chemical catalyst, or by the application of radiation.

During curing, the adhesive 130 may shrink from the predetermined volume 138 in the cured state C shown in Figures 1 and 2C, forming the tapered shape 142 of the exterior bond surface 140 that has the lateral extent 144 within the vertical projection 117. The tapered shape 142 of the exterior bond surface 140 may also have the lateral extent 144 within the vertical projection 117 prior to curing in the uncured state U.

The adhesive 130 formed with the tapered shape 142 of the exterior bond surface 140, which is disposed within the vertical projection 117, limits or prevents damage to the piezoelectric element 110 during curing to the cured state C. Because the adhesive 130 has the tapered shape 142 and does not extend beyond the vertical projection 117, if the adhesive 130 shrinks during curing, only minimal bending stress is applied to the piezoelectric element 110 on the side surfaces 114 toward the substrate 120. After curing and during use of the sensor 100, thermal cycles also impose bending stresses on the piezoelectric element 110 due to the difference in thermal expansion between the adhesive 130 and the piezoelectric element 110. The arrangement of the adhesive 130 applies minimal bending stress especially on the portions of the inner surface 112 of the piezoelectric element 110 adjacent to the side surfaces 114 during thermal cycling, minimizing cyclic fatigue. The limiting of bending stress due to the adhesive 130 arrangement prevents cracking or other bending damage to the piezoelectric element 110, ensuring greater reliability of the sensor 100.

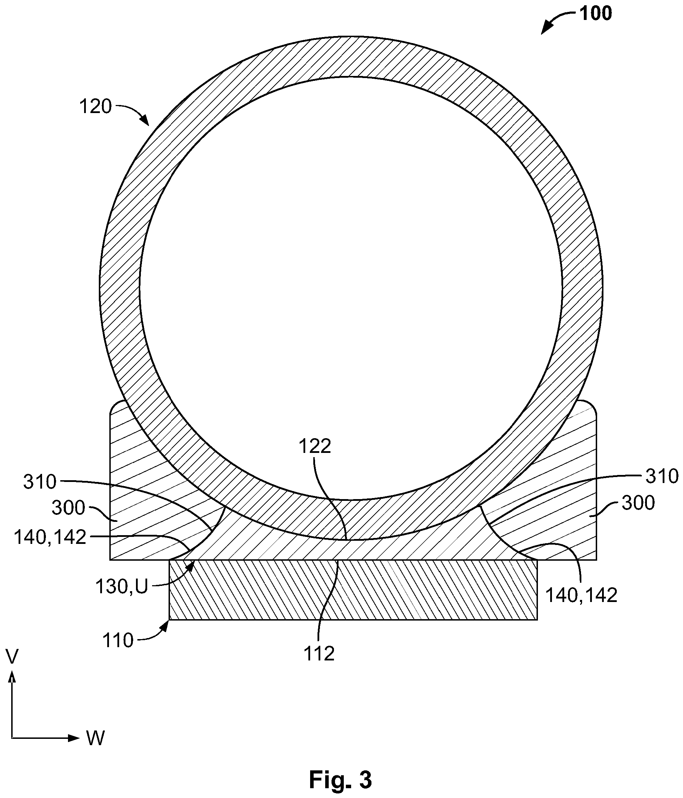

A method of constructing the sensor 100 according to an embodiment of the present invention is shown in Figure 3. Like reference numbers refer to like elements, and only the differences from the embodiment shown in Figures 2A-2C will be described in detail.

In the embodiment of the method shown in Figure 3, a plurality of wedges 300 are used to create the tapered shape 142 of the exterior bond surface 140. The wedges 300 are each formed of a resiliently compressible material, such as a foam or a soft potting.

In the embodiment shown in Figure 3, with the adhesive 130 in the uncured state U pressed by the substrate 120 and spread between the inner surface 112 of the piezoelectric element 110 and the curved surface 122 of the substrate 120, similarly to the state of the sensor 100 in the other embodiment shown in Figure 2B, the wedges 300 are moved along the width direction W and positioned between the piezoelectric element 110 and the curved surface 122 in contact with the exterior bond surface 140. The wedges 300 each have a wedge surface 310 that corresponds to the tapered shape 142 of the exterior bond surface 140. The wedges 300 form the tapered shape 142 by constraining the adhesive 130 with the wedge surfaces 310 as the adhesive 130 is cured from the uncured state U into the cured state C.

When the adhesive 130 has reached the cured state C, in an embodiment, the wedges 300 are removed and the sensor 100 is formed as shown in Figures 1 and 2C. In another embodiment, the wedges 300 may remain with the sensor 100 as shown in Figure 3. If the wedges 300 remain with the sensor 100, the wedges 300 do not transfer a load between the piezoelectric element 110 and the substrate 120 due to a compressibility of the material of the wedges 300 or due to a non-stick coating, such as Teflon, that is applied to the wedges 300 and prevents adherence to the piezoelectric element 110 and the substrate 120.

The wedge surfaces 310, in the embodiment shown in Figure 3, each have a convex shape forming a concave tapered shape 142 of the exterior bond surface 140. In other embodiments, the wedge surfaces 310 could have a concave shape to form a convex tapered shape 142, could have a linear shape to form a linear tapered shape 142, or could have an irregular shape to form an irregular tapered shape 142.

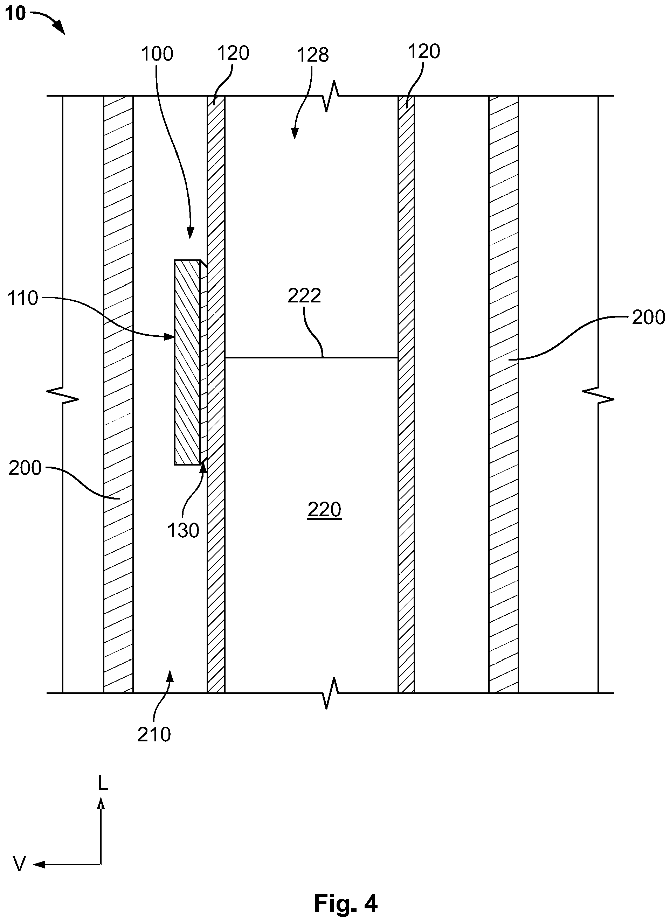

As shown in Figure 4, the sensor 100 according to the embodiments described above can be integrated into a sensor assembly 10. The sensor assembly 10 includes a vessel 200 and the sensor 100 disposed in the vessel 200. The sensor assembly 10 shown in Figure 4 is only an exemplary application of the sensor 100. Figure 4 shows a section of the sensor assembly 10 taken along a plane in the vertical direction V and a longitudinal direction L perpendicular to the vertical direction V and the width direction W.

The vessel 200, as shown in Figure 4, has a receiving space 210. The sensor 100 formed as shown in Figure 1 is disposed in the receiving space 210 of the vessel 200, as shown in Figure 4. In the shown embodiment, the vessel 200 is a hollow cylindrical member and the receiving space 210 has a circular cross-section. In other embodiments, the vessel 200 may be any other type of member and the receiving space 210 may have a cross-section of any shape.

As shown in Figure 4, the sensor assembly 10 contains a fluid 220 that is disposed in an interior space 128 of the substrate 120 of the sensor 100. The fluid 220 has a level 222 within the interior space 128 along the longitudinal direction L. The receiving space 210 between the substrate 120 and the vessel 200 is sealed to an outside environment and is not exposed to any fluid.

In an exemplary application, the sensor 100 is used to sense the level 222 of the fluid 220 in the interior space 128. An external voltage is applied to the piezoelectric element 110 of the sensor 100. The piezoelectric element 110 vibrates under application of the external voltage, producing ultrasonic wave echoes that pass through the substrate 120 and into the interior space 128. The ultrasonic wave echoes are detected and processed to determine the level 222 of the fluid 220 in the interior space 128. When the level 222 of the fluid 220 has reached the piezoelectric element 110 in the interior space 128 along the longitudinal direction L, the ultrasonic wave echoes reverberate and are detected for a first ringdown period. When the level 222 of the fluid 220 in the interior space 128 has not reached the piezoelectric element 110, the ultrasonic wave echoes do not reverberate as efficiently, and the wave echoes are detected for a second ringdown period that is shorter than the first ringdown period.

In the exemplary application shown in Figure 4, the adhesive 130 of the sensor 100 formed with the tapered shape 142 of the exterior bond surface 140, which is disposed within the vertical projection 117 as shown in Figure 1, produces a longer ringdown period when the level 222 of the fluid 220 has reached the piezoelectric element 110 in the interior space 128 than for a sensor according to the prior art. For example, the sensor according to the prior art, having the adhesive surrounding the piezoelectric element and disposed beyond the vertical projection of the piezoelectric element onto the substrate, may produce a first ringdown period of approximately 400 µs. In the same vessel 200 with the same application conditions, the sensor 100 according to the present invention may produce, for example, a first ringdown period of approximately 800 µs. The longer first ringdown period of the sensor 100 with the fluid 220 at the level of the piezoelectric element 110 creates a better signal ratio in comparison to the second ringdown period in the absence of the fluid 200 at the piezoelectric element 110, which produces a stronger and more reliable determination of the level 222 of the fluid 220.

## Claims

1. A sensor (100), comprising:
a substrate (120) having a curved surface (122);
a piezoelectric element (110); and
an adhesive (130) disposed between the piezoelectric element (110) and the curved surface (122) along a vertical direction (V) and attaching the piezoelectric element (110) to the substrate (120), the adhesive (130) has an exterior bond surface (140) that has a tapered shape (142) along the vertical direction (V) from the piezoelectric element (110) to the curved surface (122), wherein the adhesive (130) has a planar side (134) and a curved side (136) opposite the planar side (134), the planar side (134) abuts an inner surface (112) of the piezoelectric element (110) and the curved side (136) abuts the curved surface (122), and wherein the exterior bond surface (140) extends between the planar side (134) and the curved side (136) and defines a lateral extent (144) of the adhesive (130) in a width direction (W) extending perpendicular to the vertical direction (V), **characterized in that**
the lateral extent (144) of the adhesive (130) is greater at the planar side (134) attached to the piezoelectric element (110) than at the curved side (136) attached to the curved surface (122).

2. The sensor (100) of claim 1, wherein the lateral extent (144) of the adhesive (130) is disposed within a vertical projection (117) of a perimeter (116) of the piezoelectric element (110) in the vertical direction (V) toward the curved surface (122).

3. The sensor (100) of claim 1, wherein the piezoelectric element (110) has a piezoelectric width (118) in the width direction (W) and the substrate (120) has an inner diameter (126) in the width direction (W), a ratio of the piezoelectric width (118) to the inner diameter (126) is greater than or equal to 0.2 and less than or equal to 2.0.

4. The sensor (100) of claim 1, wherein the adhesive (130) is a matching layer (150) matching a mechanical impedance between the substrate (120) and the piezoelectric element (110).

5. A sensor assembly (10), comprising:
a vessel (200); and
a sensor (100) disposed in the vessel (200), the sensor (100) being in accordance with any one of claims 1 to 4, wherein the sensor (100) measures a level (222) of a fluid (220) contained within an interior space (128) of the substrate (120).

6. The sensor assembly (10) of claim 5,
wherein the exterior bond surface (140) defines a lateral extent (144) of the adhesive (130) in a width direction (W) extending perpendicular to the vertical direction (V), the lateral extent (144) of the adhesive (130) is disposed within a vertical projection (117) of a perimeter (116) of the piezoelectric element (110) in the vertical direction (V) toward the curved surface (122).

7. A method of constructing a sensor (100), comprising:
providing a piezoelectric element (110);
depositing an adhesive (130) on the piezoelectric element (110); and
positioning a curved surface (122) of a substrate (120) on the adhesive (130), the adhesive (130) is disposed between the piezoelectric element (110) and the curved surface (122) along a vertical direction (V) and attaches the piezoelectric element (110) to the substrate (120), the adhesive (130) has an exterior bond surface (140) that has a tapered shape (142) along the vertical direction (V) from the piezoelectric element (110) to the curved surface (122);
**characterized by** positioning a plurality of wedges (300) between the piezoelectric element (110) and the curved surface (122) to form the tapered shape (142) of the exterior bond surface (140).

8. The method of claim 7, wherein the adhesive (130) has a planar side (134) and a curved side (136) opposite the planar side (134), the planar side (134) abuts an inner surface (112) of the piezoelectric element (110) and the curved side (136) abuts the curved surface (122).

9. The method of claim 8, wherein the exterior bond surface (140) extends between the planar side (134) and the curved side (136) and defines a lateral extent (144) of the adhesive (130) in a width direction (W) extending perpendicular to the vertical direction (V).

10. The method of claim 9, wherein the lateral extent (144) of the adhesive (130) is disposed within a vertical projection (117) of a perimeter (116) of the piezoelectric element (110) in the vertical direction (V) toward the curved surface (122).

11. The method of claim 7, wherein the adhesive (130) is cured to attach the piezoelectric element (110) to the substrate (120).

## Patentansprüche

1. Ein Sensor (100), aufweisend:
ein Substrat (120) mit einer gekrümmten Oberfläche (122);
ein piezoelektrisches Element (110); und
einen Klebstoff (130), der zwischen dem piezoelektrischen Element (110) und der gekrümmten Oberfläche (122) entlang einer vertikalen Richtung (V) angeordnet ist und das piezoelektrische Element (110) an dem Substrat (120) befestigt, wobei der Klebstoff (130) eine äußere Klebefläche (140) aufweist, die entlang der vertikalen Richtung (V) von dem piezoelektrischen Element (110) zu der gekrümmten Oberfläche (122) eine sich verjüngende Form (142) aufweist, wobei der Klebstoff (130) eine ebene Seite (134) und eine gekrümmte Seite (136) gegenüber der ebenen Seite (134) aufweist, die ebene Seite (134) an eine Innenfläche (112) des piezoelektrischen Elements (110) anstößt und die gekrümmte Seite (136) an die gekrümmte Oberfläche (122) anstößt, und wobei sich die äußere Klebefläche (140) zwischen der ebenen Seite (134) und der gekrümmten Seite (136) erstreckt und eine seitliche Ausdehnung (144) des Klebstoffs (130) in einer Breitenrichtung (W) definiert, die sich senkrecht zu der vertikalen Richtung (V) erstreckt, **dadurch gekennzeichnet, dass** die seitliche Ausdehnung (144) des Klebstoffs (130) an der ebenen Seite (134), die an dem piezoelektrischen Element (110) befestigt ist, größer ist als an der gekrümmten Seite (136), die an der gekrümmten Oberfläche (122) befestigt ist.

2. Der Sensor (100) nach Anspruch 1, wobei die seitliche Ausdehnung (144) des Klebstoffs (130) innerhalb einer vertikalen Projektion (117) eines Umfangs (116) des piezoelektrischen Elements (110) in der vertikalen Richtung (V) zur gekrümmten Oberfläche (122) hin angeordnet ist.

3. Der Sensor (100) nach Anspruch 1, wobei das piezoelektrische Element (110) eine piezoelektrische Breite (118) in der Breitenrichtung (W) aufweist und das Substrat (120) einen Innendurchmesser (126) in der Breitenrichtung (W) aufweist, wobei ein Verhältnis der piezoelektrischen Breite (118) zum Innendurchmesser (126) größer oder gleich 0,2 und kleiner oder gleich 2,0 ist.

4. Der Sensor (100) nach Anspruch 1, wobei der Klebstoff (130) eine Anpassungsschicht (150) ist, die eine mechanische Impedanz zwischen dem Substrat (120) und dem piezoelektrischen Element (110) anpasst.

5. Eine Sensoranordnung (10), aufweisend:
einen Behälter (200); und
einen in dem Gefäß (200) angeordneten Sensor (100), wobei der Sensor (100) einem der Ansprüche 1 bis 4 entspricht, wobei der Sensor (100) einen Pegel (222) eines in einem Innenraum (128) des Substrats (120) enthaltenen Fluids (220) misst.

6. Die Sensoranordnung (10) nach Anspruch 5, wobei die äußere Klebefläche (140) eine seitliche Ausdehnung (144) des Klebstoffs (130) in einer Breitenrichtung (W) definiert, die sich senkrecht zur vertikalen Richtung (V) erstreckt, wobei die seitliche Ausdehnung (144) des Klebstoffs (130) innerhalb einer vertikalen Projektion (117) eines Umfangs (116) des piezoelektrischen Elements (110) in der vertikalen Richtung (V) zur gekrümmten Oberfläche (122) hin angeordnet ist.

7. Ein Verfahren zum Herstellen eines Sensors (100), aufweisend:
Bereitstellen eines piezoelektrischen Elements (110);
Aufbringen eines Klebstoffs (130) auf das piezoelektrische Element (110); und
Positionieren einer gekrümmten Oberfläche (122) eines Substrats (120) auf dem Klebstoff (130), wobei der Klebstoff (130) zwischen dem piezoelektrischen Element (110) und der gekrümmten Oberfläche (122) entlang einer vertikalen Richtung (V) angeordnet ist und das piezoelektrische Element (110) an dem Substrat (120) befestigt, wobei der Klebstoff (130) eine äußere Klebefläche (140) aufweist, die entlang der vertikalen Richtung (V) von dem piezoelektrischen Element (110) zu der gekrümmten Oberfläche (122) eine verjüngte Form (142) aufweist; **gekennzeichnet durch** Positionieren einer Vielzahl von Keilen (300) zwischen dem piezoelektrischen Element (110) und der gekrümmten Oberfläche (122), um die konische Form (142) der äußeren Klebefläche (140) zu bilden.

8. Das Verfahren nach Anspruch 7, wobei der Klebstoff (130) eine ebene Seite (134) und eine gekrümmte Seite (136) gegenüber der ebenen Seite (134) aufweist, wobei die ebene Seite (134) an einer Innenfläche (112) des piezoelektrischen Elements (110) anliegt und die gekrümmte Seite (136) an der gekrümmten Oberfläche (122) anliegt.

9. Das Verfahren nach Anspruch 8, wobei sich die äußere Klebefläche (140) zwischen der ebenen Seite (134) und der gekrümmten Seite (136) erstreckt und eine seitliche Ausdehnung (144) des Klebstoffs (130) in einer Breitenrichtung (W) definiert, die sich senkrecht zur vertikalen Richtung (V) erstreckt.

10. Das Verfahren nach Anspruch 9, wobei die seitliche Ausdehnung (144) des Klebstoffs (130) innerhalb einer vertikalen Projektion (117) eines Umfangs (116) des piezoelektrischen Elements (110) in der vertikalen Richtung (V) zur gekrümmten Oberfläche (122) hin angeordnet ist.

11. Das Verfahren nach Anspruch 7, wobei der Klebstoff (130) ausgehärtet wird, um das piezoelektrische Element (110) an dem Substrat (120) zu befestigen.

## Revendications

1. Capteur (100), comprenant :
un substrat (120) ayant une surface incurvée (122) ;
un élément piézoélectrique (110) ; et
un adhésif (130) disposé entre l'élément piézoélectrique (110) et la surface incurvée (122) le long d'une direction verticale (V) et fixant l'élément piézoélectrique (110) au substrat (120), l'adhésif (130) a une surface de liaison extérieure (140) qui a une forme effilée (142) le long de la direction verticale (V) de l'élément piézoélectrique (110) à la surface incurvée (122), dans lequel l'adhésif (130) a un côté plan (134) et un côté incurvé (136) à l'opposé du côté plan (134), le côté plan (134) vient en butée contre une surface intérieure (112) de l'élément piézoélectrique (110) et le côté incurvé (136) vient en butée contre la surface incurvée (122), et dans lequel la surface de liaison extérieure (140) s'étend entre le côté plan (134) et le côté incurvé (136) et définit une étendue latérale (144) de l'adhésif (130) dans une direction de la largeur (W) s'étendant perpendiculairement à la direction verticale (V),
**caractérisé en ce que** l'étendue latérale (144) de l'adhésif (130) est plus grande sur le côté plan (134) fixé à l'élément piézoélectrique (110) que sur le côté incurvé (136) fixé à la surface incurvée (122).

2. Capteur (100) selon la revendication 1, dans lequel l'étendue latérale (144) de l'adhésif (130) est disposée dans une projection verticale (117) d'un périmètre (116) de l'élément piézoélectrique (110) dans la direction verticale (V) vers la surface incurvée (122).

3. Capteur (100) selon la revendication 1, dans lequel l'élément piézoélectrique (110) a une largeur piézoélectrique (118) dans la direction de la largeur (W) et le substrat (120) a un diamètre intérieur (126) dans la direction de la largeur (W), un rapport de la largeur piézoélectrique (118) au diamètre intérieur (126) est supérieur ou égal à 0,2 et inférieur ou égal à 2,0.

4. Capteur (100) selon la revendication 1, dans lequel l'adhésif (130) est une couche d'adaptation (150) adaptant une impédance mécanique entre le substrat (120) et l'élément piézoélectrique (110).

5. Assemblage de capteur (10), comprenant :
un récipient (200) ; et
un capteur (100) disposé dans le récipient (200), le capteur (100) étant selon l'une quelconque des revendications 1 à 4, dans lequel le capteur (100) mesure un niveau (222) d'un fluide (220) contenu dans un espace intérieur (128) du substrat (120).

6. Assemblage de capteur (10) selon la revendication 5,
dans lequel la surface de liaison extérieure (140) définit une étendue latérale (144) de l'adhésif (130) dans une direction de la largeur (W) s'étendant perpendiculairement à la direction verticale (V), l'étendue latérale (144) de l'adhésif (130) est disposée à l'intérieur d'une projection verticale (117) d'un périmètre (116) de l'élément piézoélectrique (110) dans la direction verticale (V) vers la surface incurvée (122).

7. Procédé de construction d'un capteur (100) comprenant :
la fourniture d'un élément piézoélectrique (110) ;
la dépose d'un adhésif (130) sur l'élément piézoélectrique (110) ; et
le positionnement d'une surface incurvée (122) d'un substrat (120) sur l'adhésif (130), l'adhésif (130) est disposé entre l'élément piézoélectrique (110) et la surface incurvée (122) le long d'une direction verticale (V) et fixe l'élément piézoélectrique (110) au substrat (120), l'adhésif (130) a une surface de liaison extérieure (140) qui a une forme effilée (142) le long de la direction verticale (V) de l'élément piézoélectrique (110) jusqu'à la surface incurvée (122) ;
**caractérisé par** le positionnement d'une pluralité de cales (300) entre l'élément piézoélectrique (110) et la surface incurvée (122) pour former la forme effilée (142) de la surface de liaison extérieure (140).

8. Procédé selon la revendication 7, dans lequel l'adhésif (130) a un côté plan (134) et un côté incurvé (136) opposé au côté plan (134), le côté plan (134) vient en butée contre une surface intérieure (112) de l'élément piézoélectrique (110) et le côté incurvé (136) vient en butée contre la surface incurvée (122).

9. Procédé selon la revendication 8, dans lequel la surface de liaison extérieure (140) s'étend entre le côté plan (134) et le côté incurvé (136) et définit une étendue latérale (144) de l'adhésif (130) dans une direction de la largeur (W) s'étendant perpendiculairement à la direction verticale (V).

10. Procédé selon la revendication 9, dans lequel l'étendue latérale (144) de l'adhésif (130) est disposée à l'intérieur d'une projection verticale (117) d'un périmètre (116) de l'élément piézoélectrique (110) dans la direction verticale (V) vers la surface incurvée (122).

11. Procédé selon la revendication 7, dans lequel l'adhésif (130) est durci pour fixer l'élément piézoélectrique (110) au substrat (120).
